# EUROPÄISCHE PATENTSCHRIFT

(11) **EP 1 931 189 B1**
(45) Veröffentlichungstag und Bekanntmachung des Hinweises auf die Patenterteilung: **29.07.2009**
(21) Anmeldenummer: 06025297.0
(22) Anmeldetag: 07.12.2006
(51) Int. Cl.: H05K 9/00, H05K 1/02

(54) **Elektronische Schaltung und Verfahren zur Reduzierung von EMV-Störungen in dieser Schaltung**
Electronic circuit and method for reducing EMC malfunctions in this circuit
Circuit électronique et procédé de réduction des perturbations électromagnétiques dans ce circuit

(43) Veröffentlichungstag der Anmeldung: 11.06.2008
(73) Patentinhaber: Hekatron Vertriebs GmbH, 79295 Sulzburg (DE)
(72) Erfinder: Jäcklin, Samuel, 79418 Schliengen-Niedereggenen (DE)
(74) Vertreter: Maucher, Wolfgang

(56) Entgegenhaltungen:
- DE-A1- 10 023 354
- JP-A- 11 297 875
- US-A- 5 453 713
- US-A- 5 561 584
- US-A- 5 861 783
- US-A1- 2006 090 929
- US-B1- 6 614 663
- US-B1- 6 624 536

## Beschreibung

Die Erfindung betrifft eine elektronische Schaltung mit mindestens einer ersten leitenden Fläche, die im wesentlichen ein einziges Potential aufweist und wenigstens teilweise um eine zweite leitende Fläche, die im wesentlichen das gleiche elektrische Potential wie die erste leitende Fläche aufweist, herum angebracht ist. Außerdem betrifft die Erfindung ein Verfahren zur Reduzierung von EMV-Störungen in einer solchen Schaltung.

Elektronische Schaltungen, die neben analogen auch digitale Schaltungs-Komponenten aufweisen, haben häufig mit dem Problem zukämpfen, dass sich elektrische Schaltimpulse aus dem digitalen Bereich der Schaltung in den analogen Bereich der Schaltung ausbreiten und so die korrekte Arbeit der analogen Bauteile stören. Dies ist in besonderem Maße der Fall, wenn es sich bei den analogen Bauteilen um empfindliche Sensoren handelt.

Daher werden, wie z. B. in der US 5,561,584 gezeigt, in solchen Schaltungen häufig Flächen gleichen Potentials wie Masseflächen oder Flächen welche die Versorgungsspannung führen in einen digitalen und einen analogen Bereich aufgetrennt, die über einen schmalen Steg miteinander verbunden bleiben. Diese Anordnung vermag das Eindringen von Störungen, welche durch digitale Impulse hervorgerufen wurden, in den analogen Schaltungsbereich zu reduzieren, jedoch nicht vollständig zu unterbinden und schränkt dabei aber den Schaltungsdesigner bei der Positionierung der Bauteile ein.

Aus der US 5,453,713 ist ein integrierter Schaltkreis mit digitalen Schaltungen bekannt, der eine analoge Insel enthält. Die analoge Insel ist dabei durch eine Art Einkerbung elektrisch von dem digitalen Schaltkreis isoliert. Dadurch können kaum noch Störungen aus dem digitalen Schaltkreis in den analogen Schaltkreis gelangen. Die Fläche, welche die analoge Insel umgibt, wirkt jedoch wie eine Rahmenantenne und kann somit elektromagnetische Wellen aus der Umgebung empfangen. Da die Abmessungen in einem integrierten Schaltkreis jedoch sehr klein sind, liegen die empfangbaren Frequenzen in einem extrem hohen Frequenzbereich, der die Schaltung möglicherweise nicht mehr stört. Für elektronische Baugruppen, die auf gedruckten Leiterplatten untergebracht sind, können wegen der größeren Abmessungen auch elektromagnetische Wellen empfangen werden, die die korrekte Funktion der gesamten Schaltung erheblich beeinträchtigen. Daher ist diese Art der Schaltkreistrennung für elektronische Schaltungen, deren geometrische Abmessungen über die von üblichen integrierten Schaltkreisen hinausgehen nicht mehr bedenkenlos einsetzbar.

Aus der US 6,624,536 B1 wiederum ist eine Vorrichtung zum reduzieren von elektromagnetischen Störungen bekannt. Diese Vorrichtung besteht aus einer Antenne, deren Enden mit einem Widerstand verbunden sind. Elektromagnetische Energie, die von der Antenne empfangen wird, wird in dem Widerstand in Wärme umgewandelt. Die Vorrichtung wird auf eine bestehende elektronische Schaltung aufgebracht und dient dazu elektromagnetische Strahlung, die von der Schaltung abgestrahlt wird aufzunehmen, damit diese nicht in die Umgebung der Schaltung gelangt. Die Vorrichtung ist jedoch nicht geeignet, Einstrahlungen von elektromagnetischer Energie in eine Schaltung zu verhindern, oder die Auswirkungen von in die Schaltung eingestrahlter elektromagnetischer Energie oder interne Störungen zu verringern.

Schließlich offenbart die US 6,614,663 B1 eine elektronische Schaltung mit je einer Masse- und Versorgungspotentialfläche. Um Abstrahlungen elektromagnetischer Wellen über ein an die Schaltung angeschlossenes Kabel zu reduzieren, werden die Masse- und Versorgungspotentialfläche in jeweils einen inneren und einen äußeren Bereich geteilt. Der äußere Bereich umgibt den inneren Bereich. Um stehende Wellen im äußeren Bereich zu vermeiden, ist dieser in regelmäßigen Abständen an mehreren Stellen eingeschnitten oder aufgetrennt und dort mit einem Widerstand verbunden. Die Verminderung der stehenden Wellen funktioniert hier jedoch nur eingeschränkt und gelingt nicht für alle Frequenzen.

Der Erfindung liegt daher die Aufgabe zugrunde, eine elektronische Schaltung und ein Verfahren bereitzustellen, mit der elektromagnetische Störungen in der elektronischen Schaltung weiter reduziert werden können und dem Schaltungsdesigner mehr Freiheit bei der Positionierung der Bauteile lassen.

Diese Aufgabe wird bei einer Schaltung der eingangs genannten Art durch die Merkmale des Kennzeichens des Hauptanspruchs bzw. der nebengeordneten Ansprüche gelöst. Vorteilhafte Ausgestaltungen werden in den Unteransprüchen beschrieben.

Gemäß einem ersten Aspekt der Erfindung umfasst eine erfindungsgemäße elektronische Schaltung mindestens eine erste leitende Fläche, die im Wesentlichen ein einziges elektrisches Potential aufweist. Dabei soll die Formulierung "im Wesentlichen ein einziges elektrisches Potential" in dem Sinne verstanden werden, dass Potentialunterschiede innerhalb der Fläche, die auf die Ausbreitung elektromagnetischer Wellen in dieser Fläche zurückzuführen sind, als das gleiche Potential angesehen werden.

Dabei ist die erste leitende Fläche wenigstens teilweise um eine zweite leitende Fläche, die im Wesentlichen das gleiche elektrische Potential wie die erste leitende Fläche aufweist, herum angebracht. Die erste leitende Fläche ist an mindestens einer ersten Trennstelle eingeschnitten und/oder aufgetrennt. Die sich dadurch ergebenden Enden der ersten Fläche sind mit einer reellen Impedanz verbunden, welche die innerhalb der ersten Fläche vagabundierende HF-Energie in Wärme umwandelt. Bevorzugt entspricht der Wert der reellen Impedanz dem Wert des Wellenwiderstandes der aufgetrennten ersten leitenden Fläche. Der Wellenwiderstand kann dafür durch Berechnung oder Messung bestimmt werden.

Besonders bevorzugt entspricht der Wert der reellen Impedanz dem doppelten Wert des Wellenwiderstandes der aufgetrennten ersten leitenden Fläche.

In einer bevorzugten Ausführungsform, ist die erste leitende Fläche an mindestens einer zweiten Stelle eingeschnitten und/oder aufgetrennt. Auch diese zweite Trennstelle ist mit einer reellen Impedanz überbrückt, deren Wert bevorzugt dem Wert des Wellenwiderstandes und besonders bevorzugt den doppeltem Wert des Wellenwiderstandes entspricht.

In einer besonderen Ausprägung dieser Ausführungsform ist aus der ersten leitenden Fläche ein Teil elektrisch komplett heraus getrennt und an allen Trennstellen mit einer reellen Impedanz an die ursprüngliche Fläche angebunden.

In einer weiteren bevorzugten Ausführungsform hat der Abstand zwischen der ersten und der zweiten Trennstelle einen Wert der kein ganzzahliges Vielfaches einer Wellenlänge beträgt, deren zugehörige Welle sich als stehende Welle in der Fläche zwischen den beiden Enden der ersten Trennstelle ausbilden kann.

In einer Ausprägung der vorigen Ausführungsformen ist die erste und/oder zweite leitende Fläche eine Massefläche.

In einer anderen Ausprägung der vorigen Ausführungsformen liegt die erste und/oder zweite leitende Fläche auf Versorgungspotential.

In einer weiteren Ausführungsform ist mindestens eine der reellen Impedanzen, welche die erste und oder zweite Trennstelle überbrücken als längs ausgedehnter Flächenwiderstand ausgebildet.

In einer weiteren Ausprägung der vorigen Ausführungsformen enthält die elektronische Schaltung eine Sensorverstärkerschaltung.

In einer Variante dieser Ausprägung ist die Sensorverstärkerschaltung mit der zweiten leitenden Fläche elektrisch verbunden.

In einer weiteren Ausführungsform, ist die erste und/oder zweite leitende Fläche ein Bestandteil einer gedruckten Leiterplatte.

In einer besonders bevorzugten Ausführungsform ist die elektronische Schaltung ein Bestandteil eines Brandmelders.

Ein weiterer Aspekt der Erfindung ist es eine erste elektronische Schaltung bereitzustellen, die, als Bestandteil einer zweiten elektronischen Schaltung aus mindestens einer ersten leitenden Fläche besteht, die im Wesentlichen ein einziges Potential aufweist. Dabei ist die erste leitende Fläche an mindestens einer ersten Trennstelle eingeschnitten und/oder aufgetrennt und der nicht leitende Bereich zwischen den sich ergebenden Enden der ersten leitenden Fläche ist mit einer reellen Impedanz überbrückt, welche die innerhalb der Fläche vagabundierende HF-Energie in Wärme umwandelt. Vorzugsweise weist dabei die erste leitende Fläche eine ringartige Form auf und umgibt eine zweite Fläche gleichen Potentials.

Gemäß einem weiteren Aspekt der Erfindung soll ein Verfahren zur Verminderung von elektromagnetischen Störungen innerhalb einer elektronischen Schaltung angegeben werden. Nach dem erfindungsgemäßen verfahren wird zunächst eine erste leitende Fläche der elektronischen Schaltung, innerhalb der sich im Wesentlichen ein einziges elektrisches Potential befindet eingeschnitten und/oder aufgetrennt. Im Folgenden wird der Wellenwiderstand der leitenden ersten Fläche durch Rechnung oder Messung bestimmt und die nicht leitende Trennstelle, die sich beim Auftrennen der ersten leitenden Fläche ergibt, mit einer reellen Impedanz überbrückt. Vorzugsweise wird dabei eine reelle Impedanz gewählt, die in ihrem Wert dem Wellenwiderstand und besonders bevorzugt dem doppelten Wellenwiderstand entspricht.

In einer bevorzugten Weiterentwicklung des erfindungsgemäßen Verfahrens werden die Resonanzfrequenzen bzw. deren Wellenlängen bestimmt, die sich in der aufgetrennten leitenden Fläche noch ausbilden können. Dann wird eine Entfernung festlegt, deren Betrag kein ganzzahliges Vielfaches der Wellenlängen dieser Resonanzfrequenzen ist. Schließlich wird die leitende Fläche im Abstand der festgelegten Entfernung von der ersten Trennstelle aus an einer zweiten Trennstelle aufgetrennt und die zweite Trennstelle ebenfalls mit einer reellen Impedanz überbrückt.

Die Erfindung wird nachstehend anhand von Ausführungsbeispielen in der Zeichnung näher erläutert, wobei beispielhaft für eine elektronische Schaltung die Schaltung eines Rauchmelders für die Erklärung Verwendung findet. Es zeigen hierbei in teilweise stark schematisierter Darstellung die
- Fig. 1: die Anordnung einer Potentialebene einer erfindungsgemäßen elektronischen Schaltung;
- Fig. 2: die Anordnung einer Potentialebene einer erfindungsgemäßen elektronischen Schaltung in einer bevorzugten Ausführungsform.

Rauchmelder, die nach dem Tyndalleffekt arbeiten, verfügen über mindestens einen Lichtsender und mindestens einen Photoempfänger, der an Rauch gestreutes Licht empfängt, welches vom Sender ausgestrahlt wurde, und in ein elektrisches Signal umwandelt. Dieses noch schwache Signal wird dann einer analogen Verstärkerschaltung zum aufbereiten zugeführt. Häufig bestehen Rauchmelder neben diesem analogen Schaltungsteil auch aus einem digital arbeitenden Schaltungsteil, der den ganzen Messablauf steuert, und die analog-digital gewandelten Messsignale auswertet. Digitale Signale wie Taktsignale, welche die Arbeitsgeschwindigkeit der Digitalschaltung vorgeben, enthalten steile Flanken und somit viele Frequenzen. Diese können sich über gemeinsam benutzte Schaltungskomponenten wie die Systemmasse oder die Systemversorgungsspannung in der ganzen Schaltung bis in den analogen Bereich ausbreiten und können dort die Messung beeinflussen. Insbesondere bei hochempfindlichen Messsystemen wie Rauchmeldern, können Messergebnisse durch diese elektromagnetischen Störungen, die sich innerhalb der Leiterplatte fortpflanzen, verfälscht werden. In der Regel werden für die Systemmasse und die Zuführung der Versorgungsspannung (power plane) leitende Flächen verwendet, die dieses Verhalten begünstigen.

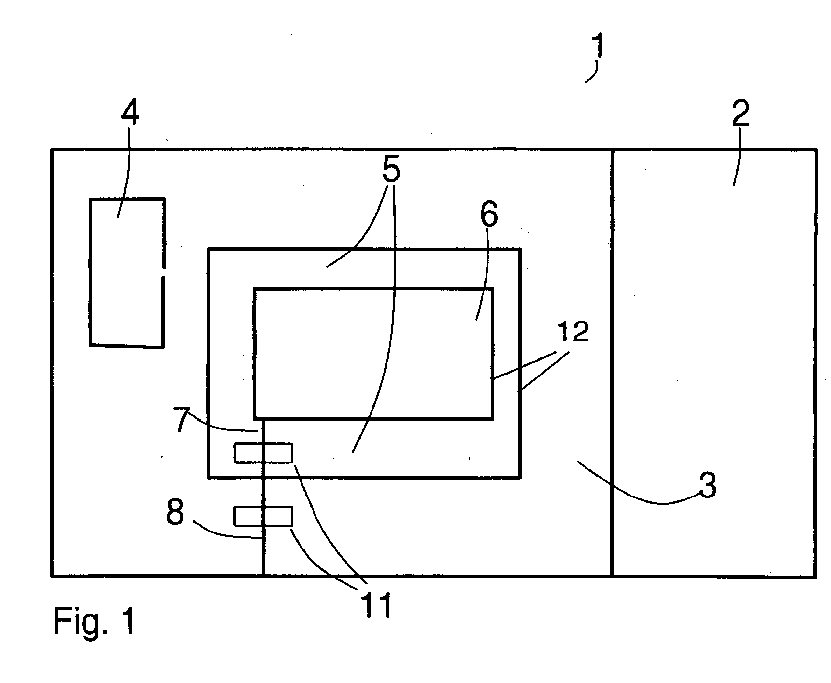

Um derartige Störungen zu vermeiden sieht die vorliegende Erfindung zum einen vor, Flächen gleichen Potentials in digitale und analoge Bereiche aufzuteilen. Fig. 1 zeigt dazu eine Ebene einer insgesamt mit 1 bezeichnete Leiterplatte, in der die Massefläche 2, 3, 4, 5, 6 der elektronischen Schaltung eines Rauchmelders dargestellt ist. Die in der Figur gezeigte Fläche kann auch eine Versorgungsspannungsebene (power plane) oder eine andere Fläche, die auf einem beliebigen Potential liegt, darstellen. Sie wird jedoch im Folgenden beispielhaft als Massenfläche beschrieben. Fig. 1 zeigt einen Flächenbereich 3, der die digitale Masse darstellt. Innerhalb der digitalen Masse 3 befindet sich ein Bereich 4 welcher einer Oszillatorschaltung zugeordnet ist. Dieser ist weitgehend von einer nicht leitenden Barriere umgeben, damit elektromagnetische Wellen an der Ausbreitung in den übrigen Bereich der digitalen Massefläche behindert werden. Die Fläche der digitalen Masse 3 umgibt vollständig die Massenflächen 5, 6 der analogen Schaltung. Dabei sind die analoge Masse 5 und die digitale Masse 3 durch eine erste nicht leitende Barriere 12 voneinander getrennt. Die analoge Masse 5 wiederum umgibt die analoge Sensormasse 6 und ist von dieser durch eine zweite nicht leitende Barriere 12 getrennt. Durch die erste nicht leitende Barriere 12 wird die Ausbreitung von digitalen Impulsen aus der digitalen Massefläche 3 in die analoge Massefläche 5 stark unterdrückt. Reste der digitalen Impulse die dennoch in die analoge Massefläche 5 einkoppeln, werden beim Übergang von der analogen Massefläche 5 in die, besonders zu schützende, analoge Sensormassefläche 6 nochmals an der zweiten nicht leitenden Barriere 12 stark gedämpft. Die Konstruktion die analogen Masseflächen 5, 6 innerhalb der digitalen Massefläche 3 vollkommen durch eine nicht leitende Barriere zu umgeben bringt aber den Nachteil mit sich, dass sowohl die digitale Masse 3 als auch die analoge Masse 5 wie Rahmenantennen wirken und elektromagnetische Strahlung aus der Umgebung empfangen können, welche die Funktion der gesamten elektronischen Rauchmelderschaltung stören können. Um diesem Manko entgegen zu wirken, ist die leitende Fläche der digitalen Masse 3 an einer Trennstelle 8 unterbrochen. Ebenso ist die leitende Fläche der analogen Masse 5 an einer Trennstelle 7 unterbrochen. Messungen haben gezeigt, dass allein durch das Auftrennen der digitalen und der analogen Masseflächen 3, 5 die Menge der eingefangenen elektromagnetischen Störungen reduziert wurde. Zur weiteren Verbesserung sind die Trennstellen 7, 8 in der digitalen und der analogen Massefläche 3, 5 jeweils mit einem Widerstand 11 überbrückt. Da die eingestrahlte Energie in den Widerständen 11 abgebaut wird, verringert sich der störende Einfluss, der in der digitalen und analogen Massenfläche 3, 5 empfangen elektromagnetischen Strahlung.

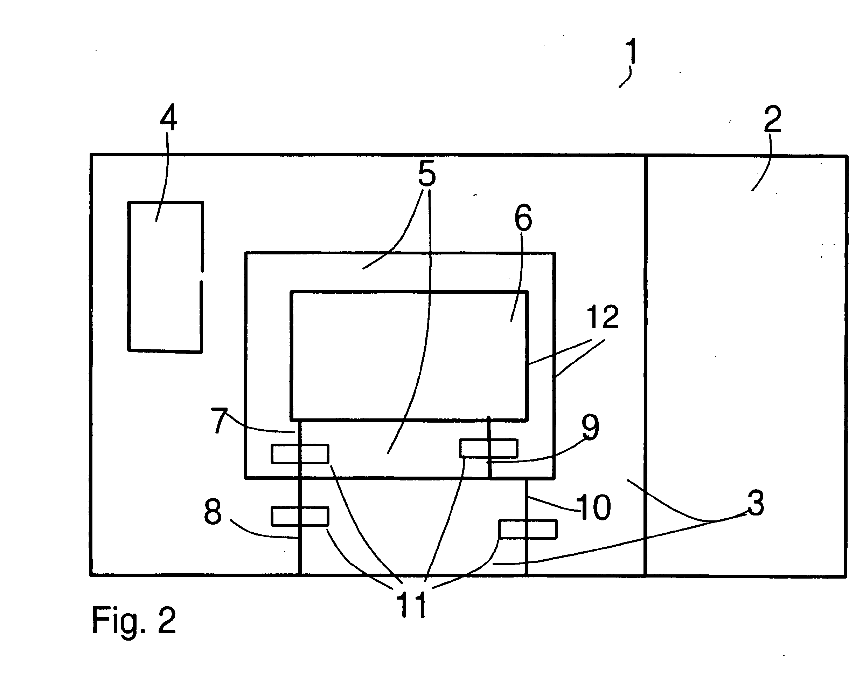

In Simulationen und Messungen zeigt es sich, dass, trotz bereits weitgehender Unterdrückung der elektromagnetischen Störungen, sich weiterhin Wellen mit bestimmten Frequenzen bzw. Wellenlängen entlang der digitalen und der analogen Massenfläche ausbreiten können. Um auch diese restlichen Störungen wirksam zu unterdrücken, sind wie in der Fig. 2 gezeigt in der digitalen Massenfläche 3 und der analogen Massenfläche 5 jeweils eine zweite Trennstelle 10, 9 eingefügt, die ebenfalls mit einem Widerstand 11 überbrückt sind. Entlang der digitalen und analogen Masseflächen 3, 5 können sich nur noch Wellen ausbreiten, die einen Spannungsbauch an den Trennstellen aufweisen. An einem Spannungsbauch einer Welle befindet sich immer ein Stromkoten, deshalb kann bei einem Spannungsbauch an einer Trennstelle kein Strom über den Überbrückungswiderstand fließen. Daher wird die Welle nicht abgebaut. Das ist der Grund, weshalb sich noch Wellen mit bestimmten Frequenzen bzw. zugehörigen Wellenlängen entlang der Masseflächen ausbreiten können. Daher muss bei der Dimensionierung der Schaltung darauf geachtet werden, dass sich entweder nur an einer ersten 7,8 oder nur an einer zweiten 9, 10 Trennstelle ein Spannungsknoten ausbilden kann. Das ist genau dann der Fall, wenn die Entfernung zwischen einer ersten Trennstellen 7, 8 und der dazugehörigen zweiten Trennstellen 9, 10 kein ganzzahliges Vielfaches einer Wellenlänge ist, die sich in der zugehörigen Massenfläche 3, 5 noch ausbreiten kann.

Deshalb ist die Entfernung zwischen der ersten Trennstelle 8 und der zweiten Trennstelle 10 in der digitalen Massenfläche 3 so gewählt, dass sie kein ganzzahliges Vielfaches einer Wellenlänge beträgt, die eine elektromagnetische Welle aufweist, welche sich zwischen den beiden Enden, welche sich an der ersten Trennstelle 8 der ersten leitenden Fläche ergeben, innerhalb der digitalen Massenfläche 3 ausbilden, solange die zweite Trennstelle 10 nicht vorhanden ist. Ebenso ist die Entfernung zwischen der ersten Trennstelle 7 und der zweiten Trennstelle 9 in der analogen Massenfläche 5 so gewählt, dass sie kein ganzzahliges Vielfaches einer Wellenlänge beträgt, die eine elektromagnetische Welle aufweist, welche sich zwischen den beiden Enden der ersten Trennstelle 7 innerhalb der analogen Massenfläche 5 ausbilden kann, solange die zweite Trennstelle 9 nicht vorhanden ist. Durch diese Dimensionierung werden sich nie gleichzeitig an den ersten Trennstellen 7, 8 und den zweiten Trennstellen 9, 10 Stromknoten ausbilden, so dass immer über mindestens einen der Widerstände 11 ein Strom fließt und die elektromagnetischen Wellen abgebaut werden. Durch die zweite Trennstelle ergibt sich, dass jeweils aus der digitalen Massenfläche 3 und der analogen Massenfläche 5 ein Teil der Fläche vollständig herausgetrennt ist, der jedoch mit den Überbrückungswiderständen 11 an die ursprünglichen Flächen angebunden ist. Alternativ dazu kann auch der heraus getrennte Flächenabschnitt selbst als längs ausgedehnter Flächenwiderstand ausgeführt werden und beide Überbrückungswiderstände 11 ersetzen. In diesem Fall ist der nicht extra dargestellte Flächenwiderstand an beide Enden an die digitale Messefläche 3 bzw. die analoge Massenfläche 5 angebunden.

Um eine möglichst gute Unterdrückung der Störungen zu bewirken, entsprechen die Werte der Überbrückungswiderstände 11 dem Wert des Wellenwiderstandes, der für die jeweilige Massenfläche 3, 5 durch Berechnung oder Messung individuell bestimmt wird. Da der Wellenwiderstand prinzipiell frequenzabhängig ist, wird der Wert des Wellenwiderstandes verwendet, der sich bei hohen Frequenzen als nahezu konstant ergibt. Eine besonders gute Unterdrückung der elektromagnetischen Störungen hat sich ergeben, wenn als Wert der Widerstände 11 der doppelte Wellenwiderstand eingesetzt wird.

Dadurch, dass die analoge Sensormasse 6 und die analoge Massenfläche 5 jeweils von einer elektrisch nicht leitenden Barriere 12 umgeben sind, wird deren direkte leitungsgebundene Beeinflussung durch die unruhige digitale Masse weitgehend unterbunden. Die analoge Massenfläche 5 wirkt sogar noch als zusätzliches Schild für die analoge Sensormasse 6. So wird die nicht dargestellte Sensorschaltung, die mit der Sensormasse 6 verbunden ist kaum noch durch digitale Signale, die sich innerhalb der digitalen Massefläche 3 fortpflanzen beeinflusst. Die ersten und zweiten Trennstellen 7, 8, 9, 10 bewirken zudem mit ihren Überbrückungswiderständen 11, dass die digitalen Signale die sich in der digitalen Massenfläche 3 fortpflanzen und die elektromagnetischen Wellen, die von der digitalen Massenfläche 3 und der analogen Massenfläche 5 empfangen werden schnell abgebaut werden.

Zusätzlich zu den bereits beschriebenen Masseflächen 3, 4, 5, 6 ist in den Figuren 1 und 2 die Massefläche der Eingangs-und Ausgangsschaltung 2 dargestellt. Diese ist mit den Schaltungskomponenten für die Kommunikation und Stromversorgung des Brandmelders verbunden. In einer nicht dargestellten Ebene der Leiterplatte 1 sind die digitale Massefläche 3 und die analoge Massefläche 5 elektrisch leitend mit der Massefläche der Eingangs- und Ausgangsschaltung 2 verbunden. Die analoge Sensormassenfläche 6 ist ebenfalls in einer nicht dargestellten Ebene der Leiterplatte 1 mit der analogen Massefläche 5 elektrisch leitend verbunden. Diese Verbindungen bewirken, dass sich keine Potentialverschiebungen zwischen den Verschiedenen Masseflächen ergeben.

Im Verfahren zur Verminderung von elektromagnetischen Störungen innerhalb einer elektronischen Schaltung, wird zunächst eine erste leitende Massefläche 3, 5 der elektronischen Schaltung aufgetrennt, innerhalb der im Wesentlichen ein einziges elektrisches Potential existiert. Die sich dabei ergebende erste Trennstelle 7, 8 wird mit einer reellen Impedanz 11 überbrückt. Zuvor wird der Wert des Wellenwiderstands der aufgetrennten ersten Fläche 3. 5 z. B. durch Berechnung oder Messung bestimmt und der Wert der reellen Impedanz 11 auf den einfachen oder besser den doppelten Wert des Wellenwiderstandes festgelegt.

Da sich in einer so entwickelten Schaltung immer noch elektromagnetische Wellen mit bestimmten Resonanzfrequenzen ausbreiten können, werden anschließend noch die Frequenzen bzw. die zugehörigen Wellenlängen dieser Wellen z. B. durch Messen bestimmt .

Sobald die Resonanzfrequenzen bzw. die zugehörigen Wellenlängen bekannt sind wird eine Entfernung festgelegt, deren Betrag kein ganzzahliges Vielfaches einer Wellenlänge dieser Resonanzfrequenzen sein soll. Schließlich wird die erste leitende Massefläche 3, 5 an einer zweiten Trennstelle 9, 10 im Abstand der festgelegten Entfernung von der ersten Trennstelle 7, 8 aufgetrennt und ebenfalls mit einer reellen Impedanz überbrückt.

Abschließend sei noch erwähnt, dass Auftrennen nicht immer im Sinne von Entfernen von leitfähigem Material zu verstehen ist. Auftrennen soll insbesondere bei der Produktion der elektronischen Schaltung auch einschließen, dass z. B. bei einer Beschichtung einer Leiterplatte mit leitendem Material die Beschichtung an den Trennstellen einfach weg gelassen wird.

## Patentansprüche

1. Elektronische Schaltung mit mindestens einer ersten und einer zweiten leitenden Fläche (3, 5), die im wesentlichen ein einziges Potential aufweisen und somit insbesondere Masse- oder versorgungspotentialflächen darstellen, wobei die erste leitende Fläche die zweite leitende Fläche umgibt, **dadurch gekennzeichnet, dass** die erste leitende Fläche (3, 5) an mindestens einer ersten Trennstelle (7, 8) eingeschnitten oder aufgetrennt ist und die sich dadurch ergebenden Enden der ersten leitenden Fläche (3, 5) mit einer reellen Impedanz (11), welche die innerhalb der ersten leitenden Fläche (3, 5) vagabundierende HF-Energie in Wärme umwandelt, verbunden sind, wobei die reelle Impedanz (11) dem Wert des einfachen oder doppelten Wellenwiderstandes der ersten leitenden Fläche entspricht.

2. Elektronische Schaltung nach Anspruch eins **dadurch gekennzeichnet, dass** die erste leitende Fläche von der zweiten leitenden Fläche durch eine nicht leitende Barriere (12) getrennt ist.

3. Elektronische Schaltung nach einem oder mehreren der vorhergehenden Ansprüche **dadurch gekennzeichnet, dass** die erste leitende Fläche (3, 5) an mindestens einer zweiten Stelle (9, 10) eingeschnitten oder aufgetrennt ist und diese zweite Trennstelle (9, 10) ebenfalls mit einer reellen Impedanz (11) überbrückt ist.

4. Elektronische Schaltung nach einem oder mehreren der vorhergehenden Ansprüche **dadurch gekennzeichnet, dass** aus der ersten leitenden Fläche (3, 5) ein Teil elektrisch komplett heraus getrennt ist und an allen Trennstellen mit einer reellen Impedanz (11) an die ursprüngliche Fläche angebunden ist.

5. Elektronische Schaltung nach einem der Ansprüche 3 oder 4 **dadurch gekennzeichnet, dass** der Abstand zwischen der ersten Trennstelle (7, 8) und der zweiten Trennstelle (9, 10) einen Wert hat der kein ganzahliges Vielfaches einer Wellenlänge beträgt, deren zugehörige Welle sich als Welle in der ersten leitenden Fläche (3, 5) zwischen den beiden Enden der ersten Trennstelle (7, 8) ausbilden kann.

6. Elektronische Schaltung nach einem oder mehreren der vorhergehenden Ansprüche **dadurch gekennzeichnet, dass** die erste leitende Fläche (3, 5) und/oder zweite leitende Fläche (6) Masseflächen sind und /oder auf Versorgungspotential liegen.

7. Elektronische Schaltung nach einem oder mehreren der vorhergehenden Ansprüche **dadurch gekennzeichnet, dass** die mindestens eine reelle Impedanz als längs ausgedehnter Flächenwiderstand ausgebildet ist.

8. Elektronische Schaltung nach einem oder mehreren der vorhergehenden Ansprüche **dadurch gekennzeichnet, dass** die elektronische Schaltung eine Sensorschaltung enthält.

9. Elektronische Schaltung nach Anspruch 8 **dadurch gekennzeichnet, dass** die Sensorschaltung mit der zweiten leitenden Fläche (6) elektrisch verbunden ist.

10. Elektronische Schaltung nach einem oder mehreren der vorhergehenden Ansprüchen **dadurch gekennzeichnet, dass** die erste leitende Fläche (3, 3) und/oder zweite Fläche (6) ein Bestandteil einer Leiterplatte ist.

11. Elektronische Schaltung nach einem oder mehreren der vorhergehenden Ansprüche **dadurch gekennzeichnet, dass** die elektronische Schaltung ein Bestandteil eines Brandmelders ist.

12. Verfahren zur Verminderung von elektromagnetischen Störungen innerhalb einer elektronischen Schaltung, **gekennzeichnet durch** folgende Verfahrensschritte:
a. Herstellen einer elektronischen Schaltung mit mindestens einer ersten und einer zweiten leitenden Fläche (3, 5), die im wesentlichen ein einziges Potential aufweisen und somit insbesondere Masse- oder Versorgungspotentialflächen darstellen, wobei die erste leitende Fläche die zweite leitende Fläche umgibt:
b. Auftrennen einer ersten leitenden Fläche (3, 5) der elektronischen Schaltung, innerhalb der im Wesentlichen ein einziges elektrisches Potential existiert und
c. Bestimmen des Wellenwiderstandes der aufgetrennten leitenden Fläche (3, 5);
d. Auswahl der reellen Impedanz (11) als Widerstand mit dem einfachen oder doppelten Wert des Wellenwiderstandes;
e. Überbrücken der sich ergebenden ersten Trennstelle (7, 8) mit der reellen Impedanz (11)

13. Verfahren nach Anspruch 12 **gekennzeichnet durch** folgende weitere Verfahrensschritte:
f. Bestimmen von Resonanzfrequenzen, die sich immer noch in der aufgetrennten leitenden Fläche (3, 5) ausbilden;
g. Festlegen einer Entfernung, deren Betrag kein ganzzahliges Vielfaches der Wellenlänge dieser Resonanzfrequenzen ist;
h. Auftrennen der leitenden Fläche an einer zweiten Trennstelle (9, 10) im Abstand der festgelegten Entfernung von der ersten Trennstelle (7, 8); und
i. Überbrücken der Trennstelle mit einer reellen Impedanz.

## Claims

1. Electronic circuit having at least one first and one second conductive surface (3, 5) which essentially have a single potential and thus constitute in particular earthing or supply potential surfaces, the first conductive surface surrounding the second conductive surface, **characterised in that** the first conductive surface (3, 5) is incised or severed at at least one first separation point (7, 8) and the resulting ends of the first conductive surface (3, 5) are connected with a real impedance (11) that converts the HF energy straying within the first conductive surface (3, 5) into heat, the real impedance (11) corresponding to once or twice the value of the wave resistance of the first conductive surface.

2. Electronic circuit according to claim 1, **characterised in that** the first conductive surface is separated from the second conductive surface by a nonconductive barrier (12).

3. Electronic circuit according to one or more of the preceding claims, **characterised in that** the first conductive surface (3, 5) is incised or severed at at least one second point (9, 10) and this second separation point (9, 10) is also bridged with a real impedance (11).

4. Electronic circuit according to one or more of the preceding claims, **characterised in that** a part is electrically completely separated from the first conductive surface (3, 5) and is connected to the original surface at all the separation points with a real impedance (11).

5. Electronic circuit according to one of claims 3 or 4, **characterised in that** the distance between the first separation point (7, 8) and the second separation point (9, 10) has a value that is not an integral multiple of a wavelength of the associated wave which may take the form of a wave in the first conductive surface (3, 5) between the two ends of the first separation point (7, 8).

6. Electronic circuit according to one or more of the preceding claims, **characterised in that** the first conductive surface (3, 5) and/or second conductive surface (6) are earthing surfaces and/or are at supply potential.

7. Electronic circuit according to one or more of the preceding claims, **characterised in that** the at least one real impedance is in the form of a surface resistance that is extended lengthways.

8. Electronic circuit according to one or more of the preceding claims, **characterised in that** the electronic circuit contains a sensor circuit.

9. Electronic circuit according to claim 8, **characterised in that** the sensor circuit is electrically connected to the second conductive surface (6).

10. Electronic circuit according to one or more of the preceding claims, **characterised in that** the first conductive surface (3, 5) and/or second surface (6) is part of a printed circuit board.

11. Electronic circuit according to one or more of the preceding claims, **characterised in that** the electronic circuit is part of a fire alarm.

12. Method of reducing electromagnetic malfunction within an electronic circuit, **characterised by** the following steps:
a. producing an electronic circuit having at least one first and one second conductive surface (3, 5) which essentially have a single potential and thus constitute in particular earthing or supply potential surfaces, the first conductive surface surrounding the second conductive surface;
b. separating a first conductive surface (3, 5) of the electronic circuit, within which there is essentially a single electrical potential, and
c. determining the wave resistance of the separated conductive surface (3, 5);
d. selecting the real impedance (11) as resistance with the same or twice the value of the wave resistance;
e. bridging the resulting first separation point (7, 8) with the real impedance (11).

13. Method according to claim 12, **characterised by** the following further steps:
f. determining resonance frequencies which are still forming in the separated conductive surface (3, 5);
g. fixing a distance the amount of which is not an integral multiple of the wavelength of these resonance frequencies;
h. separating the conductive surface at a second separation point (9, 10) at a spacing from the determined distance from the first separation point (7, 8); and
i. bridging the separation point with a real impedance.

## Revendications

1. Circuit électronique comportant au moins une première et une deuxième surfaces conductrices (3, 5) qui présentent essentiellement un seul potentiel et constituent donc en particulier des surfaces au potentiel de la masse ou de l'alimentation, la première surface conductrice entourant la deuxième surface conductrice, **caractérisé en ce que** la première surface conductrice (3, 5) est coupée ou ouverte à au moins un premier point de séparation (7, 8) et les extrémités qui en résultent de la première surface conductrice (3, 5) sont reliées à une impédance réelle (11) qui convertit en chaleur l'énergie HF qui vagabonde à l'intérieur de la première surface conductrice (3, 5), l'impédance réelle (11) correspondant à la valeur de la simple ou double impédance caractéristique de la première surface conductrice.

2. Circuit électronique selon la revendication 1, **caractérisé en ce que** la première surface conductrice est séparée de la deuxième surface conductrice par une barrière non conductrice (12).

3. Circuit électronique selon l'une ou plusieurs des revendications précédentes, **caractérisé en ce que** la première surface conductrice (3, 5) est coupée ou ouverte à au moins un deuxième point (9, 10) et ce deuxième point de séparation (9, 10) est également ponté par une impédance réelle (11).

4. Circuit électronique selon l'une ou plusieurs des revendications précédentes, **caractérisé en ce qu'**une partie de la première surface conductrice (3, 5) est complètement séparée électriquement de celle-ci et reliée à tous les points de séparation à la surface d'origine par une impédance réelle (11).

5. Circuit électronique selon l'une des revendications 3 ou 4, **caractérisé en ce que** la distance entre le premier point de séparation (7, 8) et le deuxième point de séparation (9, 10) a une valeur qui n'est pas un multiple entier d'une longueur d'onde dont l'onde correspondante peut se former dans la première surface conductrice (3, 5) entre les deux extrémités du premier point de séparation (7, 8).

6. Circuit électronique selon l'une ou plusieurs des revendications précédentes, **caractérisé en ce que** la première surface conductrice (3, 5) et/ou la deuxième surface conductrice (6) sont des surfaces de masse et/ou sont au potentiel de l'alimentation.

7. Circuit électronique selon l'une ou plusieurs des revendications précédentes, **caractérisé en ce que** l'impédance réelle au nombre d'au moins une est réalisée sous la forme d'une résistance de surface allongée dans le sens de la longueur.

8. Circuit électronique selon l'une ou plusieurs des revendications précédentes, **caractérisé en ce que** le circuit électronique contient un circuit de détection.

9. Circuit électronique selon la revendication 8, **caractérisé en ce que** le circuit de détection est relié électriquement à la deuxième surface conductrice (6).

10. Circuit électronique selon l'une ou plusieurs des revendications précédentes, **caractérisé en ce que** la première surface conductrice (3, 5) et/ou la deuxième surface conductrice (6) font partie d'une carte de circuits imprimés.

11. Circuit électronique selon l'une ou plusieurs des revendications précédentes, **caractérisé en ce que** le circuit électronique fait partie d'un détecteur d'incendie.

12. Procédé pour diminuer les perturbations électromagnétiques à l'intérieur d'un circuit électronique, **caractérisé par** les étapes de procédé suivantes :
a. fabrication d'un circuit électronique comportant au moins une première et une deuxième surfaces conductrices (3, 5) qui présentent essentiellement un seul potentiel et constituent donc en particulier des surfaces au potentiel de la masse ou de l'alimentation, la première surface conductrice entourant la deuxième surface conductrice ;
b. coupure d'une première surface conductrice (3, 5) du circuit électronique à l'intérieur de laquelle il existe essentiellement un seul potentiel électrique et
c. détermination de l'impédance caractéristique de la surface conductrice (3, 5) coupée ;
d. sélection de l'impédance réelle (11) en tant que résistance ayant une valeur simple ou double de l'impédance caractéristique ;
e. pontage du premier point de séparation (7, 8) qui en résulte avec l'impédance réelle (11).

13. Procédé selon la revendication 12, **caractérisé par** les étapes de procédé supplémentaires suivantes :
f. détermination de fréquences de résonance qui se forment toujours dans la surface conductrice (3, 5) coupée ;
g. détermination d'une distance dont la valeur n'est pas un multiple entier de la longueur d'onde de ces fréquences de résonance ;
h. coupure de la surface conductrice à un deuxième point de séparation (9, 10)
i. pontage du point de séparation avec une impédance réelle.
